# EUROPEAN PATENT APPLICATION

(11) **EP 2 251 915 A1**
(43) Date of publication of application: **17.11.2010**
(21) Application number: 09159883.9
(22) Date of filing: 11.05.2009
(51) Int. Cl.: H01L 33/00

(54) **Light emitting diode and light source module having same**

(71) Applicant: Foxsemicon Integrated Technology, Inc., Taiwan 350 (TW)
(72) Inventor: Hsu, Hung-Kuang, Taipei County 237 (TW); Wang, Chun-Wei, Taiwan 350 (TW)
(74) Representative: Stuttard, Garry Philip

(57) **Abstract**

An exemplary light emitting diode includes a substrate (11), an LED chip (12), a first heat conductor, and a second heat conductor. The substrate (11) comprises a first surface (110) and a second surface (112) at opposite sides thereof. At least a part of the LED chip is positioned above the first surface of the substrate, and the LED chip has a first electrode (121) and a second electrode (122). The first heat conductor (13) is attached to the second surface (112) of the substrate and electrically connected to the first electrode (121) of the LED chip. The second heat conductor (14) is extending through the first heat conductor (13) and electrically insulated from the first heat conductor, and electrically connected to the second electrode (122) of the LED chip.

## Description

The present invention relates to light emitting diodes (LEDs) with high heat-dissipation efficiency and light source modules having such light emitting diodes.

A light emitting diode is one type of semiconductor light source. The electrical and optical characteristics and life span of the LED are greatly temperature-dependent. Generally, a high working temperature causes deterioration of an internal quantum efficiency of the LED, and shortens the life span of the LED. Furthermore, the electrical resistance of a semiconductor has a negative temperature coefficient, and so tends to reduce with an increase in the working temperature. Such reduced resistance results in a larger current at a given voltage, thereby typically generating excessive heat. If the excessive heat cannot be effectively dissipated, a phenomenon of heat accumulation is likely to occur, and, accordingly, the deterioration of the LED can be expected to accelerate.

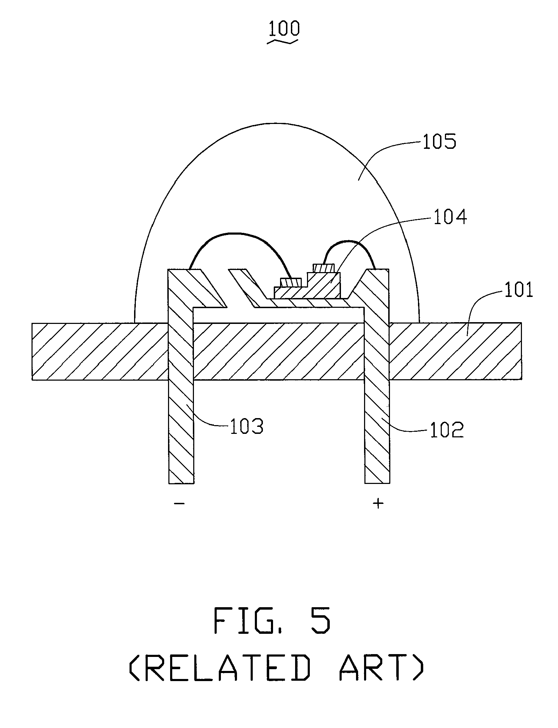

Referring to FIG. 5, a typical light emitting diode 100 includes a printed circuit board 101, a first electrode 102, a second electrode 103, an LED chip 104, and an encapsulant 105. The first electrode 102 and the second electrode 103 are positioned parallel to each other in the printed circuit board 101. The LED chip 104 is positioned on the first electrode 102, and wire bonded to the first electrode 102 and the second electrode 103. The encapsulant 105 is positioned on the printed circuit board 101 to package the LED chip 104. Any excessive heat formed by the LED chip 104 is dissipated through the encapsulant 105 and the first electrode 102. However, the thermal conductivity of the encapsulant 105 and the first electrode 102 is limited, and the excessive heat may not be effectively dissipated.

Therefore, what is needed is to provide a light emitting diode with high heat-dissipation efficiency and a light source module having such light emitting diode.

A light emitting diode, in accordance with an exemplary embodiment, is provided. The light emitting diode includes a substrate, an LED chip, a first heat conductor, and a second heat conductor. The substrate comprises a first surface and a second surface at opposite sides thereof. At least a part of the LED chip is positioned above the first surface of the substrate, and the LED chip has a first electrode and a second electrode. The first heat conductor is attached to the second surface of the substrate and electrically connected to the first electrode of the LED chip. The second heat conductor is extending through the first heat conductor and electrically insulated from the first heat conductor, and electrically connected to the second electrode of the LED chip.

Other advantages and novel features will become more apparent from the following detailed description of the present embodiments, when taken in conjunction with the accompanying drawings.

Many aspects of the present light emitting diode and light source module can be better understood with reference to the following drawings. The components in the drawings are not necessarily drawn to scale, the emphasis instead being placed upon clearly illustrating the principles of the present light emitting diode and light source module. Moreover, in the drawings, all the views are schematic, and like reference numerals designate corresponding parts throughout the several views.

FIG. 1 is a cross-sectional view of a light emitting diode, in accordance with a first embodiment.

FIG. 2 is a cross-sectional view of a light emitting diode, in accordance with a second embodiment.

FIG. 3 is an abbreviated, cross-sectional view of a light source module, in accordance with a third embodiment.

FIG. 4 is an abbreviated, top plan view of the light source module in accordance with the third embodiment.

FIG. 5 is a cross-sectional view of a typical light emitting diode, in accordance with the related art.

The exemplifications set out herein illustrate at least one exemplary embodiment, in one form, and such exemplifications are not to be construed as limiting the scope of the present light emitting diode and light source module in any manner.

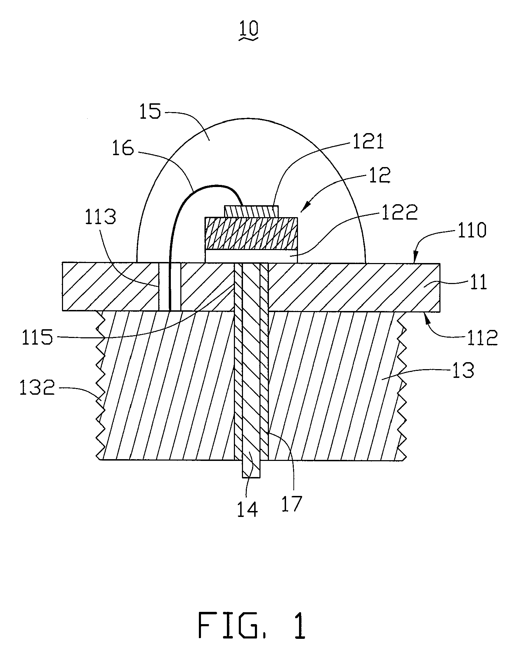

Referring to FIG. 1, a light emitting diode 10, in accordance with a first embodiment, is provided. The light emitting diode 10 includes a substrate 11, an LED chip 12, a conducting column 13, a conductive rod 14, and an encapsulant 15.

The substrate 11 has a first surface 110 and a second surface 112 at opposite sides thereof, and a first through hole 113 and a second through hole 115 each spanning between the first and the second surfaces 110, 112. The substrate 11 may be shaped like a quadrilateral, a pentagon, a hexagon, or another type of polygon. The substrate 11 may be an insulating substrate made of electrically-insulative heat-conducting material, such as glass fiber, ceramic material, etc. Alternatively, the substrate 11 may be a metallic substrate. In the present embodiment, the substrate 11 is made of ceramic material.

The LED chip 12 and the encapsulant 15 are both positioned on the first surface 110 of the substrate 11. The encapsulant 15 seals the LED chip 12 to protect the LED chip 12 from mechanical damage, moisture, and atmospheric exposure. The encapsulant 15 also increases light extraction efficiency from the LED chip 12 compared to an LED chip exposed to air.

The conducting column 13 is attached to the second surface 112 of the substrate 11. The conductive rod 14 extends through the conducting column 13 along a central axis of the conducting column 13, and through the second through hole 115 of the substrate 11. One end of the conducting column 13 firmly contacts the second surface 112. In the exemplary embodiment, the LED chip 12 has a top electrode 121 and a bottom electrode 122. The LED chip 12 includes a metal wire 16 extending through the first through hole 113 and interconnecting the top electrode 121 and the conducting column 13. The conductive rod 14, which extends through the second through hole 115, is in ohmic contact with the bottom electrode 122.

The conducting column 13 and the conductive rod 14 are used to cooperatively supply electrical power to the LED chip 12. The conducting column 13 is insulated from the conductive rod 14. In the exemplary embodiment, an insulation layer 17 is arranged between the conducting column 13 and the conductive rod 14. An end portion of the conductive rod 14 in the second through hole 115 also has the insulation layer 17 wrapped thereon, so that the conductive rod 14 is insulated from the substrate 11. In addition, an outer surface of the conducting column 13 has an outer thread 132 formed thereon, such that the light emitting diode 10 can be threadingly engaged with other devices. It can be understood that, if the substrate 11 is a metallic substrate, an insulation layer (not shown) is needed between the bottom electrode 122 of the LED chip 12 and the first surface 110 of the substrate 11.

During operation (i.e., illumination) of the LED chip 12, heat from the LED chip 12 can be effectively dissipated by the substrate 11, the conducting column 13 and the conductive rod 14 along horizontal radial directions and in a downward direction away from the LED chip 12. Thereby, the heat-dissipation efficiency of the light emitting diode 10 can be improved.

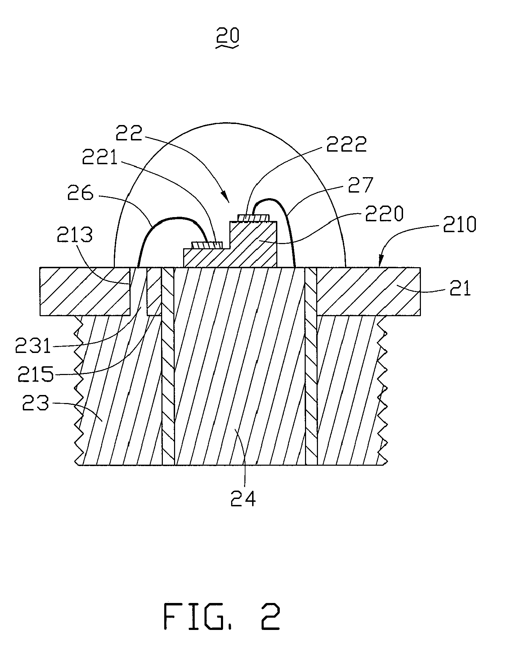

Referring to FIG. 2, a light emitting diode 20, in accordance with a second embodiment, is provided. The light emitting diode 20 is similar to the light emitting diode 10 of the first embodiment, except for the following differences:

An LED chip 22 is positioned over a substrate 21. The LED chip 22 includes a semiconductor structure 220, an anode 221, and a cathode 222. In the illustrated embodiment, the semiconductor structure 220 is a stepped block of semiconductor material. The anode 221 and cathode 222 are positioned on two steps of the semiconductor structure 220. Thus the anode 221 and cathode 222 are parallel to each other but offset from each other. A conducting column 23 has a protrusion 231 received in a first through hole 213 of the substrate 21, with the protrusion 231 extending through to a first surface 210 of the substrate 21. The anode 221 of the LED chip 22 is wire bonded to the protrusion 231 using a metal wire 26. A conductive rod 24 passes through a second through hole 215 of the substrate 21 to hold the semiconductor structure 220 and thus the LED chip 22. As shown in FIG. 2, a bottom surface of the semiconductor structure 220 is completely attached to the conductive rod 24 to achieve thermal contact therewith. The cathode 222 of the LED chip 22 is wire bonded to the conductive rod 24 using another metal wire 27.

In the exemplary embodiment, the conducting column 23 and the conductive rod 24 are used to cooperatively supply electrical power to the LED chip 22. When the LED chip 22 operates, heat from the LED chip 22 can be effectively dissipated by the conductive rod 24, the conducting column 23 and the substrate 21, along horizontal radial directions and in a downward direction away from the LED chip 22. Thereby, the heat-dissipation efficiency of the light emitting diode 20 can be improved.

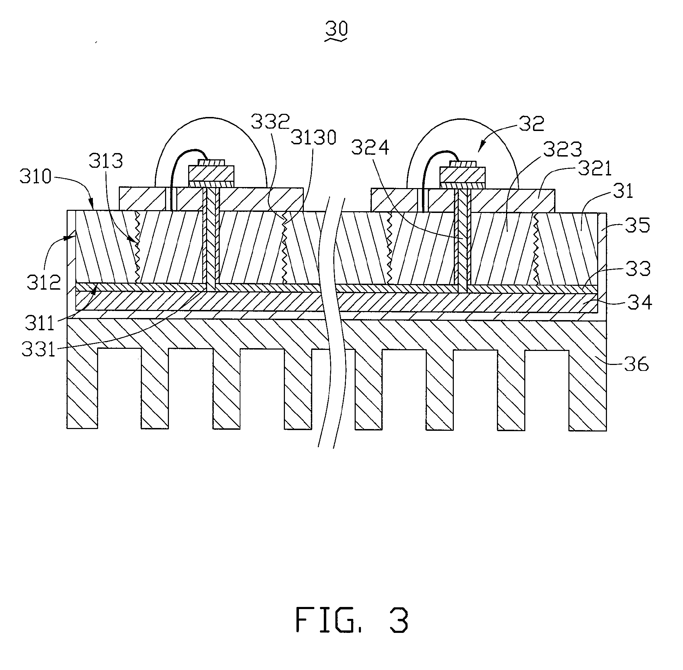

Referring to FIG. 3, a light source module 30, in accordance with a third embodiment, is shown. The light source module 30 includes a heat-dissipating plate 31, a number of light emitting diodes 32, an inner insulation layer 33, a conductive film 34, an outer insulation layer 35, and a number of heat dissipation fins 36.

The heat-dissipating plate 31 has a third surface 310 and a fourth surface 311 at opposite sides thereof, and a peripheral side surface 312 located between the third surface 310 and the fourth surface 311. A number of parallel third through holes 313 are defined in the heat-dissipating plate 31, with each third through hole 313 spanning between the third and the fourth surfaces 310, 311. An inner wall of the heat-dissipating plate 31 that bounds each third through hole 313 has an inner thread 3130 formed thereon, for threadedly engaging with an outer thread 332 of a respective conducting column 323. Thus, the conducting columns 323 of the light emitting diodes 32 are threadedly engaged in the third through holes 313 of the heat-dissipating plate 31. Thereby, the light emitting diodes 32 can be fixed on the heat-dissipating plate 31.

Each light emitting diode 32 can for example be the light emitting diode 10 of the first embodiment or the light emitting diode 20 of the second embodiment.

The inner insulation layer 33, the conductive film 34, and the outer insulation layer 35 are arranged on the fourth surface 311 of the heat-dissipating plate 31, in that order. The inner insulation layer 33 is adjacent to the fourth surface 311 of the heat-dissipating plate 31, and has a number of fourth through holes 331 defined therein. The fourth through holes 331 correspond to and communicate with the third through holes 313.

One end of the conductive rod 324 of each light emitting diode 32 far from the substrate 321 extends through the corresponding fourth through hole 31 and is electrically connected to the conductive film 34. The outer insulation layer 35 may be located only on the side of the conductive film 34 far from the inner insulation layer 33, or may be further located also on the side surface 312 of the heat-dissipating plate 31. In the illustrated embodiment, the outer insulation layer 35 is located on both the side of the conductive film 34 far from the inner insulation layer 33 and the side surface 312. The heat dissipation fins 36 share a common base portion (not labeled), and advantageously extend away from the outer insulation layer 35 in a direction essentially orthogonal to the conductive film 34.

In the exemplary embodiment, the heat-dissipating plate 31 and the conductive film 34 are used to cooperatively supply electrical power to the LED chips 32. When the LED chips 32 operate, heat from the LED chips 32 can be effectively dissipated by the substrates 321 and the conducting columns 323 to the heat-dissipating plate 31. Because the heat-dissipating plate 31 has a large heat-dissipating area, the light source module 30 can achieve high heat-dissipation efficiency. The heat-dissipating plate 31 and the heat dissipation fins 36 generally are made from material with high heat conductivity, such as aluminum (Al), copper (Cu), or an alloy thereof.

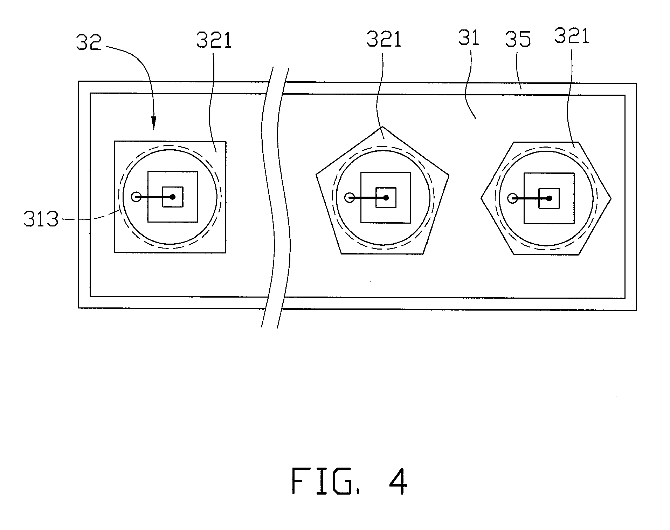

Referring to FIG. 4, the shapes of the substrates 321 may vary. For example, each substrate 321 can be, but is not limited to, quadrilateral-shaped, pentagon-shaped, or hexagon-shaped. A torsional load can advantageously be applied to the substrate 321 by a suitable wrench. Thus, the conducting column 323 of the light emitting diode 32 can be conveniently screwed into the corresponding third through hole 313.

It is believed that the present embodiments and their advantages will be understood from the foregoing description, and it will be apparent that various changes may be made thereto without departing from the spirit and scope of the invention or sacrificing all of its material advantages, the examples hereinbefore described merely being preferred or exemplary embodiments of the present invention.

## Claims

1. A light emitting diode (LED) comprising:
a substrate including a first surface and a second surface at opposite sides thereof;
an LED chip at least a part of which is positioned above the first surface of the substrate, wherein the LED chip comprises a first electrode and a second electrode;
a first heat conductor attached to the second surface of the substrate and electrically connected to the first electrode of the LED chip; and
a second heat conductor extending through the first heat conductor and electrically insulated from the first heat conductor and electrically connected to the second electrode of the LED chip.

2. A light emitting diode as claimed in claim 1 further comprising an insulation layer between the first heat conductor and the second heat conductor.

3. A light emitting diode as claimed in claim 1 or 2 wherein the substrate further includes a first through hole and a second through hole each spanning between the first and the second surfaces, wherein the LED further comprises a metal wire extending through the first through hole and interconnecting the first electrode and the first heat conductor and the second heat conductor extends through the second through hole and is in ohmic contact with the second electrode of the LED chip.

4. A light emitting diode as claimed in claim 3, wherein the first heat conductor includes a protrusion received in the first through hole of the substrate and the metal wire extending through the first through hole is connected to the protrusion.

5. A light emitting diode as claimed in claim 1, wherein the LED chip further includes a stepped semiconductor block, wherein the first electrode and the second electrode are positioned on two steps of the semiconductor block respectively, wherein a first metal wire interconnects the first electrode and the first heat conductor and a second metal wire interconnects the second electrode and the second heat conductor.

6. A light emitting diode as claimed in claim 5, wherein a bottom surface of the semiconductor structure is attached to the second heat conductor thereby achieving thermal contact therewith.

7. A light emitting diode as claimed in any preceding claim wherein the first heat conductor has an outer thread formed thereon.

8. A light emitting diode as claimed in any preceding claim wherein the substrate is polygon-shaped.

9. A light source module comprising:
at least one light emitting diode (LED), each of said at least one light emitting diodes comprising:
a substrate including a first surface and a second surface at opposite sides thereof;
an LED chip at least a part of which is positioned above the first surface of the substrate, wherein the LED chip comprises a first electrode and a second electrode,
a first heat conductor positioned on the second surface of the substrate and electrically connected to the first electrode of the LED chip, and
a second heat conductor extending through the first heat conductor and electrically insulated from the first heat conductor and electrically connected to the second electrode of the LED chip; and
a heat-dissipating plate including a third surface and a fourth surface at opposite sides thereof, a peripheral side surface between the third surface and the fourth surface and at least one third through hole spanning between the third and the fourth surfaces, wherein said at least one light emitting diode is received in the at least one third through hole.

10. A light source module as claimed in claim 9, wherein said at least one light emitting diode is threadedly engaged in the at least one third through hole.

11. A light source module as claimed in claim 9 or 10 further comprising an inner insulation layer, a conductive film and an outer insulation layer arranged on the fourth surface of the heat-dissipating plate in that order, wherein the inner insulation layer is adjacent to the fourth surface of the heat-dissipating plate, the conductive film is electrically connected to the second heat conductor of the LED and the outer insulation layer is located on a side of the conductive film far from the inner insulation layer.

12. A light source module as claimed in any of claims 9 to 11 further comprising a plurality of heat dissipation fins extending away from the outer insulation layer in a direction essentially orthogonal to the conductive film.

13. A light source module as claimed in any of claims 9 to 12 further comprising an insulation layer between the first heat conductor and the second heat conductor.

14. A light source module as claimed in any of claims 9 to 13, wherein the substrate further includes a first through hole and a second through hole each spanning between the first and the second surfaces, wherein the LED further comprises a metal wire extending through the first through hole and interconnecting the first electrode and the first heat conductor and the second heat conductor extends through the second through hole and is in ohmic contact with the second electrode of the LED chip.

15. A light source module as claimed in claim 14, wherein the first heat conductor includes a protrusion received in the first through hole of the substrate and the metal wire extending through the first through hole is connected to the protrusion.

16. A light source module as claimed in claim 9, wherein the LED chip further includes a stepped semiconductor block, wherein the first electrode and the second electrode are positioned on two steps of the semiconductor block respectively, wherein a first metal wire interconnects the first electrode and the first heat conductor and a second metal wire interconnects the second electrode and the second heat conductor.

17. A light source module as claimed in any of claims 9 to 16, wherein the first heat conductor has an outer thread formed thereon.

18. A light source module comprising:
a plurality of light emitting diodes (LEDs), each light emitting diode comprising:
a substrate including a first surface and a second surface at opposite sides thereof;
an LED chip at least a part of which is positioned above the first surface of the substrate, wherein the LED chip comprises a first electrode and a second electrode,
a first metallic heat conductor attached on the second surface of the substrate and electrically connected to the first electrode of the LED chip, and
a second metallic heat conductor extending through the first heat conductor and electrically insulated from the first heat conductor and electrically connected to the second electrode of the LED chip; and
a metallic heat dissipating member including a plurality of receiving holes receiving the first heat conductors of the respective light emitting diodes therein.

19. A light source module as claimed in claim 18, wherein the first heat conductors of the light emitting diodes are threadedly engaged in the receiving holes of the heat dissipating member.

20. A light source module as claimed in claim 18, wherein the first heat conductors of the light emitting diodes are electrically coupled to the heat dissipating member.
